(19) **Europäisches Patentamt**
**European Patent Office**
**Office européen des brevets**

(11) **EP 1 880 096 B1**

(12) **EUROPÄISCHE PATENTSCHRIFT**

(45) Veröffentlichungstag und Bekanntmachung des Hinweises auf die Patenterteilung:
**28.10.2009 Patentblatt 2009/44**

(21) Anmeldenummer: **06742322.8**

(22) Anmeldetag: **12.05.2006**

(51) Int Cl.:
*F02D 41/02* (2006.01)     *F16H 61/02* (2006.01)
*F16K 29/00* (2006.01)     *B60G 17/018* (2006.01)
*H03K 5/01* (2006.01)

(86) Internationale Anmeldenummer:
**PCT/DE2006/000814**

(87) Internationale Veröffentlichungsnummer:
**WO 2006/119751 (16.11.2006 Gazette 2006/46)**

(54) **VERFAHREN UND EINRICHTUNG ZUR ELEKTRISCHEN ANSTEUERUNG EINES VENTILS MIT EINEM MECHANISCHEN SCHLIEßELEMENT**

METHOD AND DEVICE FOR ELECTRICALLY ACTUATING A VALVE WITH A MECHANICAL CLOSING ELEMENT

PROCEDE ET DISPOSITIF DE COMMANDE ELECTRIQUE D'UNE SOUPAPE AU MOYEN D'UN ELEMENT DE FERMETURE MECANIQUE

(84) Benannte Vertragsstaaten:
**DE FR**

(30) Priorität: **12.05.2005 DE 102005022063**

(43) Veröffentlichungstag der Anmeldung:
**23.01.2008 Patentblatt 2008/04**

(73) Patentinhaber: **Conti Temic microelectronic GmbH**
**90411 Nürnberg (DE)**

(72) Erfinder: **LEIPNITZ, Klaus**
**90542 Eckental (DE)**

(56) Entgegenhaltungen:
**DE-A1- 10 160 477     US-A- 6 067 490**

**Beschreibung**

Die Erfindung betrifft ein Verfahren und eine Einrichtung zur elektrischen Ansteuerung eines Ventils mit einem mechanischen Schließelement. Bei dem Verfahren wird das Schließelement mittels eines in einer Spule fließenden elektrischen Stromes bewegt, und der elektrische Strom mittels eines pulsweitenmodulierten PWM-Signals erzeugt, das eine vorgegebene PWM-Periodendauer und ein Tastverhältnis aufweist. Die Einrichtung umfasst einen PWM-Generator zur Erzeugung eines pulsweitenmodulierten PWM-Signals, das eine vorgegebene PWM-Periodendauer und ein Tastverhältnis aufweist, und auf Basis dessen eine Einspeisung eines elektrischen Stromes in eine mit dem Schließelement zusammenwirkende Spule erfolgt.

Ein derartiges Verfahren und eine derartige Einrichtung kommen beispielsweise in der Automobiltechnik zum Einsatz. Bei dem Ventil kann es sich um ein Hydraulikventil zur Steuerung eines hydraulischen Systems handeln. Die mechanische Verstellung des Schließelements erfolgt mittels des PWM-Signals. Das Schließelement hat eine gegenüber der Gleitreibung stärker ausgeprägte Haftreibung, so dass der sogenannte Stick-Slip-Effekt auftreten kann. Um dies zu verhindern, wird einem für die Grundstellung des Schließelements verantwortlichen Grundanteil im Tastverhältnis des PWM-Signals ein Überlagerungsanteil hinzugefügt, der das Schließelement in eine zyklische Bewegung um die Grundstellung versetzt. Es kann aber zu Betriebszuständen kommen, bei denen der für die kontinuierliche Bewegung des Schließelements verantwortliche Überlagerungsanteil nicht mit der Amplitude vorgesehen werden kann, die eigentlich zur Vermeidung des Stick-Slip-Effekts erforderlich wäre.

Der Erfindung liegt deshalb die Aufgabe zugrunde, ein Verfahren der eingangs bezeichneten Art so anzugeben, dass eine zur Vermeidung des Stick-Slip-Effekts ausreichende Bewegung des Schließelements gewährleistet ist.

Diese Aufgabe wird erfindungsgemäß durch ein Verfahren mit denen im Anspruch 1 angegebenen Merkmalen gelöst.

Falls einer der fiktiven Tastverhältniswerte bei Zugrundelegung des ursprünglich vorgesehenen Überlagerungsanteils außerhalb der zulässigen Grenzen zwischen Null und Eins liegt, wird erfindungsgemäß das Tastverhältnissignal und insbesondere der Überlagerungsanteil korrigiert. Es wurde erkannt, dass ein Abrücken von einem symmetrischen Überlagerungsanteil mit gleicher positiver und negativer Amplitude die Möglichkeit eröffnet, trotz der Korrektur eine im Wesentlichen unveränderte mechanische Bewegung des Schließelements zu erzielen. Um außerdem im Wesentlichen auch eine Mittelwertneutralität dieser Korrektur zu gewährleisten, wird ein Überlagerungsumschaltzeitpunkt, zu dem zwischen dem hohen und dem niedrigen Tastverhältniswert umgeschaltet wird, von der Mitte der Überlagerungsperiodendauer (= symmetrischer Fall) auf einen anderen Zeitpunkt verschoben. Als besonders effizient hat es sich dabei herausgestellt, den korrigierten Überlagerungsumschaltzeitpunkt so zu wählen, dass er mit einem Rasterpunkt des durch die PWM-Periodendauer gebildeten Rasters zusammenfällt. Dadurch können insbesondere die anderen Parameter des Verfahrens, wie beispielsweise die PWM-Periodendauer, unverändert beibehalten werden. Ein geringfügiges Abweichen von der idealerweise angestrebten exakten Mittelwertneutralität kann durch die üblichen Rundungs- oder Berechnungsgenauigkeiten hervorgerufen werden. Vorteilhafte Ausgestaltungen des erfindungsgemäßen Verfahrens ergeben sich aus den von Anspruch 1 abhängigen Ansprüchen.

Die Variante nach Anspruch 2 bietet die Möglichkeit zur Überwachung der Ventilansteuerung und insbesondere auch zur Anpassung an sich ändernde Vorgaben. Insbesondere der Grundanteil kann nämlich mit der Zeit variieren, beispielsweise wenn der von einer übergeordneten Steuer- oder Regeleinheit vorgegebene Sollwert Schwankungen unterworfen ist.

Die gemäß Anspruch 3 zusätzlich vorgesehene Tiefpassfilterung filtert die PWM-Frequenz und zumindest teilweise auch die Überlagerungsfrequenz aus dem Messwert. Dadurch vereinfacht sich die Regelung, die andernfalls gegen den aus Regelungssicht als Störgröße wirkenden Überlagerungsanteil im Messwert arbeiten würde.

Bei der gemäß Anspruch 4 vorgesehenen Maßnahme ergibt sich ein korrigierter Überlagerungsumschaltzeitpunkt, der nahest möglich an der Mitte der Überlagerungsperiodendauer liegt und damit einer bevorzugten symmetrischen Überlagerung mit gleichlangen Zeitspannen für die beiden Tastverhältniswerte am nächsten kommt.

Die Variante nach Anspruch 5 ermöglicht eine einfache Einstellung der niedrigen und hohen Tastverhältniswerte und ist insbesondere auch mittelwertneutral. Dies bedeutet, dass der über eine Überlagerungsperiodendauer ermittelte arithmetische Mittelwert des Tastverhältnissignals abgesehen von den üblichen Rundungs- oder Berechnungsungenauigkeiten nicht wesentlich verändert wird.

Die Maßnahme gemäß Anspruch 6 bietet im Wesentlichen die gleichen Vorteile, die bereits im Zusammenhang mit Anspruch 4 genannt worden sind.

Eine weitere Aufgabe der Erfindung besteht darin, eine Einrichtung der eingangs bezeichneten Art so anzugeben, dass eine zur Vermeidung des Stick-Slip-Effekts ausreichende Bewegung des Schließelements gewährleistet ist.

Diese Aufgabe wird erfindungsgemäß durch eine Einrichtung mit den Merkmalen des Anspruchs 7 gelöst. Vorteilhafte Ausgestaltungen der erfindungsgemäßen Einrichtung ergeben sich aus den von Anspruch 7 abhängigen Ansprüchen. Die erfindungsgemäße Einrichtung und ihre Ausgestaltungen bieten im Wesentlichen die gleichen Vorteile, die bereits im Zusammenhang mit dem erfindungsgemäßen Verfahren und dessen Varianten beschrieben worden sind.

Weitere Merkmale, Vorteile und Einzelheiten der Erfindung ergeben sich aus der nachfolgenden Beschreibung eines Ausführungsbeispiels anhand der Zeichnung. Es zeigt:

Fig. 1    ein Ausführungsbeispiel einer Einrichtung zur elektrischen Ansteuerung eines Ventils in Blockschaltbilddarstellung,

Fig. 2    ein PWM-Signal sowie ein Tastverhältnissignal, die beide in der Einrichtung gemäß Fig. 1 vorkommen, und

Fig. 3 und 4    korrigierte Tastverhältnissignale.

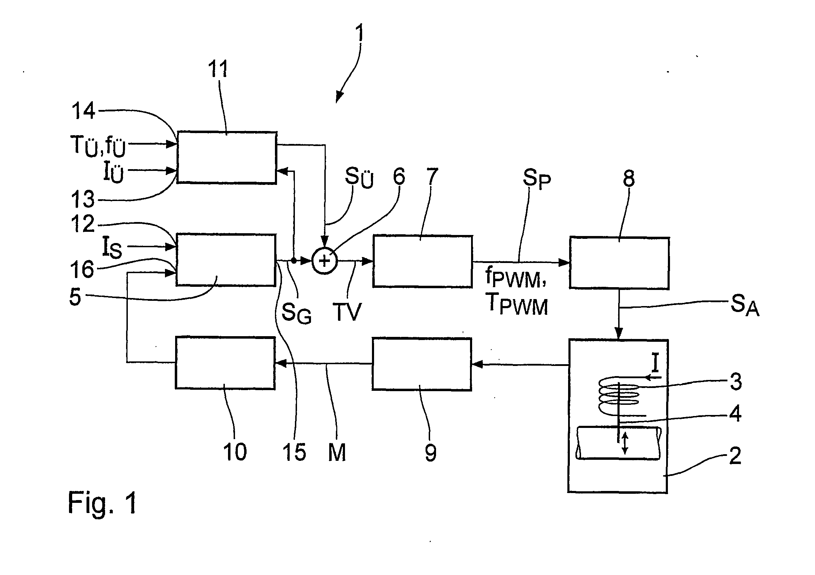

In Fig. 1 ist ein Ausführungsbeispiel einer Ansteuereinrichtung 1 zur Ansteuerung eines Hydraulikventils 2, das Bestandteil eines nicht näher gezeigten Hydraulikkreislaufes in einer Kupplungsansteuerung eines Kraftfahrzeug-Getriebes ist, dargestellt. Das Hydraulikventil 2 umfasst eine Spule 3 und ein mechanisch bewegbares Schließelement 4, die nach dem elektrodynamischen Tauchspulenprinzip zusammenwirken.

Die Ansteuereinrichtung 1 umfasst einen Regelkreis mit einem Regler 5, einem Addierer 6, einem PWM-Generator 7, einem als MOSFET-Endstufe ausgebildeten Treiber 8, einem Strommesser 9 sowie mit einem Tiefpass 10. Der zwischen dem Regler 5 und dem PWM-Generator 7 angeordnete Addierer 6 ist außerdem mit einer Überlagerungseinheit 11 verbunden. Der Regler 5 weist einen Eingang 12 auf. Die Überlagerungseinheit 11 hat zwei Eingänge 13 und 14. Die Eingänge 12 bis 14 sind zur Einspeisung von Sollwerten, die von einer übergeordneten, nicht näher dargestellten Steuer-oder Regeleinheit stammen, bestimmt. Die Überlagerungseinheit 11 ist außerdem auch an einen Ausgang 15 des Reglers 5 angeschlossen. Der Regler 5 enthält neben dem Eingang 12 einen weiteren Eingang 16, an den ein Rückkopplungszweig des Regelkreises angeschlossen ist.

Anstelle des weiteren Eingangs 16 kann auch ein dem Regler 5 vorgeschalteter Addierer/Substrahierer vorgesehen sein, in dem eine Differenz zwischen dem Sollwert und einem mittels des Rückkopplungszweiges zurückgeführten Signal gebildet wird. Das Ergebnis dieser Differenz wird dann dem Regler 5 am Eingang 12 zugeführt.

Eine weitere Alternative betrifft die Verbindung zwischen dem Ausgang 15 des Reglers 5 und der Überlagerungseinheit 11. Anstelle der in Fig. 1 gezeigten direkten Verbindung kann auch der nicht näher bezeichnete Ausgang des Addierers 6 mit einem Eingang der Überlagerungseinheit 11 verbunden sein.

Die in Fig. 1 gezeigten Teileinheiten der Ansteuereinrichtung 1 können als physikalisch getrennte (elektronische) Baugruppen oder aber als Software-Module, die auf einer Recheneinheit (beispielsweise einem MikroProzessor) ablaufen, ausgeführt sein. Eine Mischform ist ebenfalls möglich. Im Ausführungsbeispiel sind der Treiber 8 und der Strommesser 9 gesonderte elektronische Baugruppen, wohingegen die übrigen Teileinheiten als Software-Module in einer nicht näher dargestellten Recheneinheit implementiert sind.

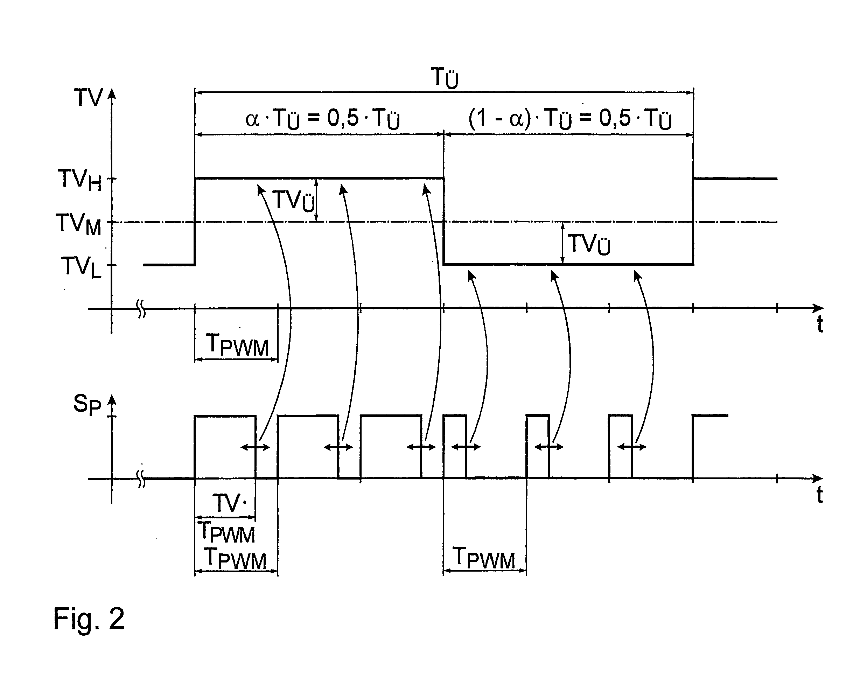

Im Folgenden wird auch unter Bezugnahme auf die in den Fig. 2 bis 4 dargestellten Diagramme die Funktionsweise der Ansteuereinrichtung 1 beschrieben.

Ein in der Spule 3 fließender Strom I bewirkt eine Positionsänderung des Schließelements 4, so dass der Öffnungsgrad des Hydraulikventils 2 eingestellt werden kann. Um den Stick-Slip-Effekt zu vermeiden, wird das Schließelement 4 in eine zyklische Bewegung um eine im Wesentlichen konstante oder zumindest nur vergleichsweise langsam veränderliche Grundstellung versetzt.

Sowohl die Grundstellung als auch die zyklische Bewegung werden mittels eines Ansteuersignals $S_A$ bewirkt, mit dem die Spule 3 beaufschlagt wird und das vom Treiber 8 auf Basis eines pulsweitenmodulierten PWM-Signals $S_P$ erzeugt wird. Das Ansteuersignal $S_A$ und das PWM-Signal $S_P$ haben im Wesentlichen die gleiche Signalform.

Das beispielhaft im unteren Diagramm von Fig. 2 über der Zeit t aufgetragene PWM-Signal $S_P$ hat eine PWM-Frequenz $f_{PWM}$, deren Kehrwert eine PWM-Periodendauer $T_{PWM}$ ist. Innerhalb der PWM-Periodendauer $T_{PWM}$ wird zu einem Umschaltzeitpunkt zwischen einer Einschaltphase und einer Ausschaltphase umgeschaltet. Ein Tastverhältnis ergibt sich als Quotient der Dauer der Einschaltphase zu der PWM-Periodendauer $T_{PWM}$.

Das Tastverhältnis des vom PWM-Generator 7 erzeugten PWM-Signals $S_P$ ist nicht konstant. Es variiert zyklisch und wird je nach Momentanwert eines am Eingang des PWM-Generators 7 anstehenden Tastverhältnissignals TV eingestellt. Dieser Zusammenhang ist in den beiden Diagrammen von Fig. 2 wiedergegeben, wobei im oberen Diagramm ein beispielhaftes Tastverhältnissignal TV und im unteren Diagramm ein daraus resultierendes PWM-Signal $S_P$ gezeigt sind.

Das Tastverhältnissignal TV hat einen rechteckförmigen Signalverlauf, der mit einer Überlagerungsperiodendauer $T_Ü$ um ein mittleres Tastverhältnis $TV_M$ schwankt. Es wechselt zwischen einem niedrigen Tastverhältniswert $TV_L$ und einem hohen Tastverhältniswert $TV_H$. Das Tastverhältnissignal TV bestimmt die jeweilige Dauer der Einschaltphase des PWM-Signals $S_P$. Dementsprechend dauert die Einschaltphase bei Vorliegen des hohen Tastverhältniswertes $TV_H$ länger als bei Vorliegen des niedrigen Tastverhältniswertes $TV_L$. Diese Variation der Dauer der Einschaltphase im PWM-Signal $S_P$ hat keinen Einfluss auf den Mittelwert des PWM-Signals $S_P$ sowie des daraus abgeleiteten elektrischen Stroms I und der letztendlich resultierenden Bewegung des Schließelements 4, da sich die Variation zyklisch mit der Überlagerungsperiodendauer $T_Ü$ wiederholt.

Wie aus dem oberen Diagramm von Fig. 2 ersichtlich, umfasst das Tastverhältnissignal TV einen im Wesentlichen konstanten oder nur sehr langsam zeitlich veränderlichen Grundanteil und einen periodischen Überlagerungsanteil. Es wird mittels Addition eines vom Regler 5 am Ausgang 15 zur Verfügung gestellten Grundsignals $S_G$ und eines von der Überlagerungseinheit 11 erzeugten Überlagerungssignals $S_Ü$ im Addierer 6 gebildet.

Das Überlagerungssignal $S_Ü$ wird auch als Dither-Signal bezeichnet. Es wird in der Überlagerungseinheit 11 aufgrund der an den Eingängen 13 und 14 vorgegebenen Werten für einen Überlagerungsstrom $I_Ü$ bzw. für eine Überlagerungsfrequenz $f_Ü$ entsprechend dem Kehrwert der Überlagerungsperiodendauer $T_Ü$ ermittelt. Diese Vorgaben bestimmen letztendlich, mit welcher Geschwindigkeit und mit welcher Amplitude die Bewegung des Schließelements 4 erfolgt. Die an den Eingängen 13 und 14 gemachten Vorgaben hängen vom Typ des Hydraulikventils 2 ab. Zusätzlich können diese Vorgaben auch unter Berücksichtigung weiterer Parameter, wie beispielsweise der Umgebungstemperatur, getroffen werden. Üblicherweise liegt die Überlagerungsfrequenz $f_Ü$ im Bereich zwischen einigen 10 Hz und einigen 100 Hz. Im Ausführungsbeispiel sind 300 Hz vorgesehen. Die Überlagerungsperiodendauer $T_Ü$ ist insbesondere ein vom Typ des Hydraulikventils 2 abhängiges ganzzahliges Vielfaches der PWM-Periodendauer $T_{PWM}$. Deren Kehrwert, also die PWM-Frequenz $f_{PWM}$, liegt typischerweise im Bereich einiger kHz. Im Ausführungsbeispiel sind 3 kHz vorgesehen.

Das für die Grundstellung des Schließelements 4 verantwortliche Grundsignal $S_G$ wird aus dem am Eingang 12 anstehenden Sollstrom $I_S$ abgeleitet. Hierzu wird im Regler 5 ein Vergleich mit der auf den Eingang 16, zurückgeführten Größe, die ein Maß für den in der Spule 3 fließenden Strom I ist, angestellt.

Die am Eingang 16 anstehende Größe ergibt sich aus einer Messung des elektrischen Stromes I mittels des Strommessers 9 und einer Filterung dieses Messwerts M im Tiefpass 10. Die Grenzfrequenz des Tiefpasses 10 ist niedrig genug, um die PWM-Frequenz $f_{PWM}$ vollständig und die Überlagerungsfrequenz $f_Ü$ zumindest teilweise aus dem Messwert M herauszufiltern. Andererseits ist sie groß genug, um die Dynamik des Regelkreises nicht zu stark zu beeinflussen.

Das Ansteuersignal $S_A$ ruft in der Spule 3 einen elektrischen Strom I hervor, dessen zeitlicher Verlauf aufgrund der Spulenträgheit nicht identisch mit dem des PWM-Signals $S_P$ ist. Aber auch der Strom I enthält einen im Wesentlichen konstanten Grundanteil und einen mit der Überlagerungsfrequenz $f_Ü$ periodisch schwankenden Überlagerungsanteil. Aufgrund der Massenträgheit des Schließelements 4 und auch aufgrund der Spulenträgheit kann die mechanische Verstellbewegung des Schließelements 4 der vergleichsweise hohen PWM-Frequenz $f_{PWM}$ nicht folgen. Dagegen ist die Überlagerungsfrequenz $f_Ü$ niedrig genug, um eine dementsprechende zyklische Bewegung des Schließelements 4 hervorzurufen, die dem unerwünschten Stick-Slip-Effekt entgegenwirkt.

In Fig. 2 sind symmetrische Verhältnisse gezeigt. Dies bedeutet, dass der niedrige und der hohe Tastverhältniswert $TV_L$ bzw. $TV_H$ um den gleichen Wert, nämlich um die Amplitude $TV_Ü$ des Überlagerungssignals $S_Ü$, vom mittleren Tastverhältnis $TV_M$ beabstandet liegen. Die Amplitude $TV_Ü$ errechnet sich gemäß

$$TV_Ü = \frac{I_Ü \cdot R}{U_B} \qquad\qquad (1)$$

aus dem Vorgabewert für den Überlagerungsstrom $I_Ü$ und einem ohmschen Spulenwiderstand R sowie einer Versorgungsspannung $U_B$, wobei in einer zulässigen Näherung nur die statischen Verhältnisse der Spule 3, also nur deren ohmscher Widerstand R, zugrunde gelegt sind.

Auch in Richtung der Zeitachse weist das Tastverhältnissignal TV eine Symmetrie auf. Der hohe und der niedrige Tastverhältniswert $TV_H$ bzw. $TV_L$ werden jeweils während einer Hälfte der Überlagerungsperiodendauer $T_Ü$ angenommen. Somit ergibt sich ein als Quotient der Dauer des hohen Tastverhältniswerts $TV_H$ und der Überlagerungsperiodendauer $T_Ü$ gebildetes Überlagerungsverhältnis $\alpha$ von 0,5.

Es gibt Betriebszustände der Ansteuereinrichtung 1, bei denen die bevorzugte in Fig. 2 gezeigte symmetrische Form des Tastverhältnissignals TV nicht möglich ist. Bei bestimmten Vorgaben für den Überlagerungsstrom $I_Ü$ und den Sollstrom $I_S$ kann - zumindest theoretisch - ein Tastverhältnissignal TV resultieren, dessen niedriger oder hoher Tastverhältniswert $TV_L$ bzw. $TV_H$ außerhalb des möglichen Wertebereichs zwischen Null und Eins liegt. Wie aus Fig. 2 ersichtlich, sind die beiden Extremfälle durch eine Einschaltphase gekennzeichnet, die entweder komplett verschwindet oder die komplette Zeitspanne der PWM-Periodendauer $T_{PWM}$ einnimmt.

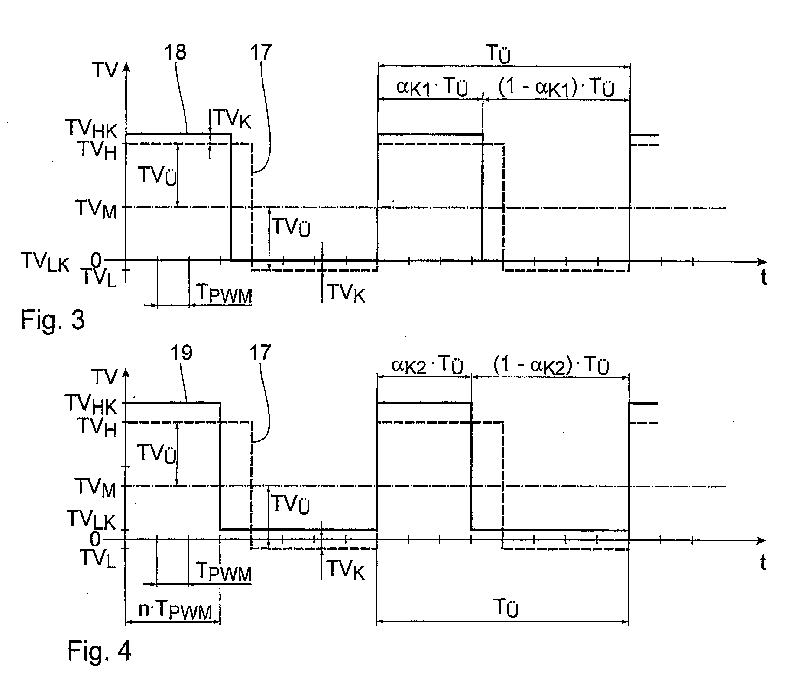

Um dennoch einen Betrieb der Ansteuereinrichtung 1 bei Vorgabewerten für den Sollstrom $I_S$ und den Überlagerungsstrom $I_Ü$ zu ermöglichen, die zu einem - fiktiven - Tastverhältnis außerhalb der zulässigen Grenzen führen, wird eine Korrektur mit einem Wechsel auf einen asymmetrischen Signalverlauf des Tastverhältnissignals TV vorgesehen. Beispiele hierzu sind in den Diagrammen von Fig. 3 und 4 dargestellt. Ein fiktiver Signalverlauf 17 des ursprünglich aufgrund der Vorgabewerte resultierenden Tastverhältnissignals TV ist jeweils in strichlierter Linienführung gezeigt, während für korrigierte Signalverläufe 18 und 19 durchgezogene Linien vorgesehen sind. In den gezeigten Beispielen unterschreitet der fiktive Signalverlauf 17 jeweils den unteren Grenzwert von Null.

Die Korrektur wird am Überlagerungssignal $S_{\ddot{U}}$ in der Überlagerungseinheit 11 vorgenommen. Zur Durchführung dieser Korrektur und der vorgeschalteten Prüfung, ob die zulässigen Grenzwerte über- oder unterschritten werden, wird der Überlagerungseinheit 11 das am Ausgang 15 des Reglers 5 aktuell anstehende Grundsignal $S_G$ zugeführt.

Grundsätzlich können diese im Ausführungsbeispiel in der Überlagerungseinheit 11 durchgeführte Prüfung und Korrektur aber auch an anderer Stelle, beispielsweise im Addierer 6 oder in einer eingangsseitig im PWM-Generator 7 vorgesehenen Untereinheit, stattfinden.

Bei der Korrektur ist zu berücksichtigen, dass die Grundstellung und die zyklische Bewegung des Schließelements 4 möglichst unverändert bleiben und entsprechend der gewünschten Vorgabewerte für den Sollstrom $I_S$ und den Überlagerungsstrom $I_{\ddot{U}}$ eingestellt werden. Daraus ergibt sich die Bedingung nach einer mittelwertneutralen Korrektur. Das mittlere Tastverhältnis $TV_M$ darf also nicht verändert werden.

Bei dem in Fig. 3 gezeigten Korrekturansatz werden der niedrige Tastverhältniswert $TV_L$ und der hohe Tastverhältniswert $TV_H$, die beide aufgrund der Vorgabewerte gemäß Gleichung (1) und insbesondere noch ohne Korrektur ermittelt werden, um einen gleichen Tastverhältniskorrekturwert $TV_K$ gemäß

$$TV_K = TV_{\ddot{U}} - TV_M \qquad (2)$$

soweit auf einen korrigierten niedrigen bzw. hohen Tastverhältniswert $TV_{LK}$ bzw. $TV_{HK}$ angehoben, dass der korrigierte niedrige Tastverhältniswert $TV_{LK}$ gerade Null wird. Der Absolutabstand zwischen den beiden Tastverhältniswerten $TV_L$ und $TV_H$ einerseits sowie $TV_{LK}$ und $TV_{HK}$ andererseits bleibt gleich, so dass auch die zyklische Bewegung des Schließelements 4 nach wie vor im gleichen Umfang gewährleistet ist.

Um auch die Forderung nach der Mittelwertneutralität zu erfüllen, werden die Zeitspannen, während derer der korrigierte niedrige und hohe Tastverhältniswert $TV_{LK}$ bzw. $TV_{HK}$ angenommen werden, verändert. Aus der Mittelwertbedingung

$$\alpha_{K1} \cdot \left(TV_M + TV_{\ddot{U}} + TV_K\right) + (1 - \alpha_{K1}) \cdot 0 = TV_M \qquad (3)$$

folgt eine Korrektur des symmetrischen Überlagerungsverhältnisses $\alpha$ mit dem Wert 0,5 auf ein korrigiertes Überlagerungsverhältnis $\alpha_{K1}$

$$\alpha_{K1} = \frac{TV_M}{TV_M + TV_{\ddot{U}} + TV_K} = \frac{TV_M}{2 \cdot TV_{\ddot{U}}} \quad , \qquad (4)$$

wobei Gleichung (2) berücksichtigt ist.

Der gemäß Gleichung (4) ermittelte Wert für das korrigierte Überlagerungsverhältnis $\alpha_{K1}$ fällt im Allgemeinen nicht in das Raster der PWM-Periodendauer $T_{PWM}$.

Bei dem in Fig. 4 gezeigten Korrekturansatz wird eine Rasterkonformität gezielt eingestellt, indem die Zeitspanne, während der der korrigierte niedrige oder hohe Tastverhältniswert $TV_{LK}$ bzw. $TV_{HK}$ angenommen wird, als ein ganzzahliges Vielfaches der PWM-Periodendauer $T_{PWM}$ gewählt wird. Ein so korrigiertes Überlagerungsverhältnis $\alpha_{K2}$ nimmt demnach die Form

$$\alpha_{K2} = \frac{n \cdot T_{PWM}}{T_{\ddot{U}}} \qquad (5)$$

an, wobei mit n eine natürliche Zahl bezeichnet ist. Die Rasterkonformität ist günstig, da sich die Ansteuereinrichtung 1 dadurch einfacher realisieren lässt. Eine bei der Korrektur mit berücksichtigte Rasterkonformität erübrigt nämlich eine ansonsten gegebenenfalls erforderliche Anpassung weiterer Parameter, wie beispielsweise der PWM-Periodendauer $T_{PWM}$.

Das korrigierte Überlagerungsverhältnis $\alpha_{K1}$ gemäß Gleichung (4) gibt eine obere Grenze an, bis zu der der korrigierte niedrige Tastverhältniswert $TV_{LK}$ einen Wert $\geq 0$ annimmt. In Verbindung mit Gleichung (5) ergibt sich damit für die ganze Zahl n folgende Bedingung:

$$n \leq \frac{TV_M}{2 \cdot TV_{\ddot{U}}} \cdot \frac{T_{\ddot{U}}}{T_{PWM}} \quad \text{und} \quad n \in \{0, 1, 2, 3, \dots\} . \qquad (6)$$

Aufgrund des beim Korrekturansatz gemäß Fig. 4 vorgesehenen Wechsels vom Überlagerungsverhältnis $\alpha_{K1}$ auf das rasterkonforme Überlagerungsverhältnis $\alpha_{K2}$ sind auch das niedrige und das hohe korrigierte Tastverhältniswert $TV_{LK}$ bzw. $TV_{HK}$ gemäß Fig. 3 zu ändern, um die Bedingung der Mittelwertneutralität einzuhalten. Ausgehend von den Verhältnissen gemäß Fig. 3 ergeben sich der niedrige und der hohe korrigierte Tastverhältniswert $TV_{LK}$ bzw. $TV_{HK}$ beim Korrekturansatz gemäß Fig. 4 dann zu:

$$\begin{aligned} TV_{LK} &= TV_M - (TV_{\ddot{U}} - TV_K) \cdot \frac{1 - \alpha_{K1}}{1 - \alpha_{K2}} = \\ &= TV_M \cdot \left[ 1 - \left( 1 - \frac{TV_M}{2 \cdot TV_{\ddot{U}}} \right) \cdot \frac{T_{\ddot{U}}}{T_{\ddot{U}} - T_{PWM} \cdot n} \right] \end{aligned} \qquad (7)$$

beziehungsweise

$$\begin{aligned} TV_{HK} &= TV_M + (TV_{\ddot{U}} + TV_K) \cdot \frac{\alpha_{K1}}{\alpha_{K2}} = \\ &= TV_M \cdot \left[ 1 + \left( 1 - \frac{TV_M}{2 \cdot TV_{\ddot{U}}} \right) \cdot \frac{T_{\ddot{U}}}{T_{PWM} \cdot n} \right] \end{aligned} , \qquad (8)$$

wobei die Gleichungen (2), (4) und (5) berücksichtigt sind.

Die vorstehend anhand der Fig. 3 und 4 beschriebenen Korrekturansätze lassen sich analog auf den Fall übertragen, dass der fiktive Signalverlauf 17 nicht den unteren Grenzwert von Null unterschreitet, sondern den oberen Grenzwert von Eins überschreitet.

**Patentansprüche**

1.  Verfahren zur elektrischen Ansteuerung eines Ventils (2) mit einem mechanischen Schließelement (4), bei dem

a) das Schließelement (4) mittels eines in einer Spule (3) fließenden elektrischen Stromes (I) bewegt wird,

b) der elektrische Strom (I) mittels eines pulsweitenmodulierten PWM-Signals ($S_P$) erzeugt wird, das eine vorgegebene PWM-Periodendauer ($T_{PWM}$) und ein Tastverhältnis aufweist,

c) das Tastverhältnis mittels eines Tastverhältnissignals (TV) eingestellt wird, das sich additiv aus einem Grundanteil ($S_G$) und einem Überlagerungsanteil ($S_Ü$) mit einer Überlagerungsperiodendauer ($T_Ü$) zusammensetzt, innerhalb der das Tastverhältnissignal (TV) zwischen einem hohen und einem niedrigen Tastverhältniswert ($TV_H$; $TV_L$; $TV_{HK}$, $TV_{LK}$) umgeschaltet wird,

d) überprüft wird, ob die Addition des Grundanteils ($S_G$) und des ursprünglich vorgesehenen Überlagerungsanteils ($S_Ü$) einen fiktiven niedrigen Tastverhältniswert ($TV_L$) von kleiner als Null oder einen fiktiven hohen Tastverhältniswert ($TV_H$) von größer als Eins liefert, und bejahendenfalls eine Korrektur vorgenommen wird, indem

d1) der niedrige Tastverhältniswert ($TV_L$) auf mindestens Null und der hohe Tastverhältniswert ($TV_H$) auf einen korrigierten hohen Tastverhältniswert ($TV_{HK}$) angehoben wird bzw. der hohe Tastverhältniswert ($TV_H$) auf höchstens Eins und der niedrige Tastverhältniswert ($TV_L$) auf einen korrigierten niedrigen Tastverhältniswert ($TV_{LK}$) abgesenkt wird, und

d2) eine Tastverhältnisdauer vom Beginn der Überlagerungsperiodendauer ($T_Ü$) bis zum Umschalten zwischen den beiden korrigierten Tastverhältniswerten ($TV_{LK}$, $TV_{HK}$) als ein ganzzahliges Vielfaches der PWM-Periodendauer ($T_{PWM}$) eingestellt wird,

wobei die Korrektur so vorgenommen wird, dass der arithmetische zeitliche Mittelwert ($TV_M$) des Tastverhältnissignals (TV) nicht wesentlich verändert wird.

2. Verfahren nach Anspruch 1, **dadurch gekennzeichnet, dass** der Grundanteil ($S_G$) ermittelt wird, indem ein Messwert (M) des in der Spule (3) fließenden elektrischen Stromes (I) bestimmt und im Rahmen einer Regelung mit einem vorgebbaren Sollwert ($I_S$) verglichen wird.

3. Verfahren nach Anspruch 2, **dadurch gekennzeichnet, dass** der Messwert (M) einer Tiefpassfilterung unterzogen wird.

4. Verfahren nach Anspruch 1, **dadurch gekennzeichnet, dass** die Tastverhältnisdauer auf das größtmögliche ganzzahlige Vielfache der PWM-Periodendauer ($T_{PWM}$) eingestellt wird.

5. Verfahren nach Anspruch 1, **dadurch gekennzeichnet, dass** der korrigierte niedrige und hohe Tastverhältniswert ($TV_{LK}$, $TV_{HK}$) gemäß

$$TV_{LK} = TV_M \cdot \left[ 1 - \left( 1 - \frac{TV_M}{2 \cdot TV_Ü} \right) \cdot \frac{T_Ü}{T_Ü - T_{PWM} \cdot n} \right]$$

bzw.

$$TV_{HK} = TV_M \cdot \left[ 1 + \left( 1 - \frac{TV_M\cdot}{2 \cdot TV_Ü} \right) \cdot \frac{T_Ü}{T_{PWM} \cdot n} \right]$$

eingestellt werden, falls die Überprüfung ergibt, dass der fiktive niedrige Tastverhältniswert kleiner als Null ist, wobei mit $TV_M$ der Grundanteil, mit $TV_Ü$ die Amplitude des ursprünglich vorgesehenen Überlagerungsanteils, mit $T_Ü$ die Überlagerungsperiodendauer, mit $T_{PWM}$ die PWM-Periodendauer und mit n eine natürliche Zahl bezeichnet ist.

6. Verfahren nach Anspruch 5, **dadurch gekennzeichnet, dass** die natürliche Zahl n auf den größten Wert, der die Bedingungen

$$n \leq \frac{TV_M}{2 \cdot TV_{\ddot{U}}} \cdot \frac{T_{\ddot{U}}}{T_{PWM}} \quad \text{und} \quad n \in \{0, 1, 2, 3, \dots\}$$

erfüllt, eingestellt wird.

7. Einrichtung zur elektrischen Ansteuerung eines Ventils (2) mit einem mechanischen Schließelement (4), umfassend

a) einen PWM-Generator (7) zur Erzeugung eines pulsweitenmodulierten PWM-Signals ($S_P$), das eine vorgegebene PWM-Periodendauer ($T_{PWM}$) und ein Tastverhältnis aufweist, und auf Basis dessen eine Einspeisung eines elektrischen Stromes (I) in eine mit dem Schließelement (4) zusammenwirkende Spule (3) erfolgt, und
b) eingangsseitig an den PWM-Generator (7) angeschlossene Bereitstellungsmittel (5, 6, 11) zur Bereitstellung eines das Tastverhältnis bestimmenden Tastverhältnissignals (TV), wobei

b1) die Bereitstellungsmittel (5, 6, 11) einen Addierer (6) enthalten, um das Tastverhältnissignal (TV) aus einem Grundanteil ($S_G$) und einem Überlagerungsanteil ($S_{\ddot{U}}$) mit einer Überlagerungsperiodendauer ($T_{\ddot{U}}$) zu erzeugen, innerhalb der das Tastverhältnissignal (TV) zwischen einem hohen und einem niedrigen Tastverhältniswert ($TV_H$, $TV_L$; $TV_{HK}$, $TV_{LK}$) wechselt,
b2) die Bereitstellungsmittel (5, 6, 11) Korrekturmittel (11) enthalten, die ausgelegt sind
b21) zur Prüfung, ob die Addition des Grundanteils ($S_G$) und des ursprünglich vorgesehenen Überlage-rungsanteils ($S_{\ddot{U}}$) einen fiktiven niedrigen Tastverhältniswert ($TV_L$) von kleiner als Null oder einen fiktiven hohen Tastverhältniswert ($TV_H$) von größer als Eins liefert,
b22) zur Wertanpassung mittels Anhebens des niedrigen Tastverhältniswerts ($TV_L$) auf mindestens Null und des hohen Tastverhältniswerts ($TV_H$) auf einen korrigierten hohen Tastverhältniswert ($TV_{HK}$) bzw. zur Wertanpassung mittels Absenkens des hohen Tastverhältniswerts ($TV_H$) auf höchstens Eins und des niedrigen Tastverhältniswerts ($TV_L$) auf einen korrigierten niedrigen Tastverhältniswert ($TVL_K$), und
b23) zur Einstellung einer Tastverhältnisdauer vom Beginn der Überlagerungsperiodendauer ($T_{\ddot{U}}$) bis zum Umschalten zwischen den beiden korrigierten Tastverhältniswerten ($TV_{LK}$, $TV_{HK}$) als ein ganzzahliges Vielfaches der PWM-Periodendauer ($T_{PWM}$),

wobei die Wertanpassung der Tastverhältniswerte ($TV_{LK}$, $TV_{HK}$) und die Einstellung der Tastverhältnisdauer den arithmetischen zeitlichen Mittelwert ($TV_M$) des Tastverhältnissignals (TV) nicht wesentlich verändern.

8. Einrichtung nach Anspruch 7, **dadurch gekennzeichnet, dass** die Bereitstellungsmittel (5, 6, 11) einen Regler (5) zum Vergleich eines Messwerts (M) des in der Spule (3) fließenden elektrischen Stromes (I) mit einem vorgebbaren Sollwert ($I_S$) enthalten.

9. Einrichtung nach Anspruch 8, **dadurch gekennzeichnet, dass** ein Tiefpass (10) zur Filterung des Messwerts (M) vorgesehen ist.

10. Einrichtung nach Anspruch 7, **dadurch gekennzeichnet, dass** die Korrekturmittel (11) ausgelegt sind zur Einstellung der Tastverhältnisdauer auf das größtmögliche ganzzahlige Vielfache der PWM-Periodendauer ($T_{PWM}$).

11. Einrichtung nach Anspruch 7, **dadurch gekennzeichnet, dass** die Korrekturmittel (11) ausgelegt sind zur Einstellung des korrigierten niedrigen und hohen Tastverhältniswerts ($TV_{LK}$, $TV_{HK}$) gemäß

$$TV_{LK} = TV_M \cdot \left[ 1 - \left( 1 - \frac{TV_M}{2 \cdot TV_{\ddot{U}}} \right) \cdot \frac{T_{\ddot{U}}}{T_{\ddot{U}} - T_{PWM} \cdot n} \right]$$

bzw.

$$TV_{HK} = TV_{M} \cdot \left[ 1 + \left( 1 - \frac{TV_{M}}{2 \cdot TV_{\ddot{U}}} \right) \cdot \frac{T_{\ddot{U}}}{T_{PWM} \cdot n} \right] \quad ,$$

falls die Überprüfung ergibt, dass der fiktive niedrige Tastverhältniswert kleiner als Null ist, wobei mit $TV_{M}$ der Grundanteil, mit $TV_{\ddot{U}}$ die Amplitude des ursprünglich vorgesehenen Überlagerungsanteils, mit $T_{\ddot{U}}$ die Überlagerungsperiodendauer, mit $T_{PWM}$ die PWM-Periodendauer und mit n eine natürliche Zahl bezeichnet ist.

**12.** Einrichtung nach Anspruch 11, **dadurch gekennzeichnet, dass** die Korrekturmittel (11) ausgelegt sind zur Einstellung der natürlichen Zahl n auf den größten Wert, der die Bedingungen

$$n \leq \frac{TV_{M}}{2 \cdot TV_{\ddot{U}}} \cdot \frac{T_{\ddot{U}}}{T_{PWM}} \quad \text{und} \quad n \in \{0, 1, 2, 3, \dots \}$$

erfüllt.

**Claims**

**1.** A method for electrically triggering a valve (2) having a mechanical closure element (4), in which

a) the closure element (4) is moved by means of an electric current (I) flowing in a coil (3),
b) the electric current (I) is generated by means of a pulse width modulated PWM signal ($S_P$) which has a predefined PWM period ($T_{PWM}$) and a duty cycle,
c) the duty cycle is adjusted by means of a duty cycle signal (TV) which is the sum of a basic portion ($S_G$) and a superimposed portion ($S_{\ddot{U}}$) having a superposition period ($T_{\ddot{U}}$) during which the duty cycle signal (TV) is switched between a high and a low duty cycle value ($TV_H$, $TV_L$, $TV_{HK}$, $TV_{LK}$),
d) it is checked whether the addition of the basic portion ($S_G$) and the originally planned superimposed portion ($S_{\ddot{U}}$) yields a fictitious low duty cycle value ($TV_L$) smaller than zero or a fictitious high duty cycle value ($TV_H$) higher than one and, if so, a correction is made by

d1) raising the low duty cycle value ($TV_L$) at least to zero and the high duty cycle value ($TV_H$) to a corrected high duty cycle value ($TV_{HK}$) or lowering the high duty cycle value ($TV_H$) at the most to one and the low duty cycle value ($TV_L$) to a corrected low duty cycle value ($TV_{LK}$), and
d2) setting a duty cycle duration from the beginning of the superposition period ($T_{\ddot{U}}$) until switching between the two corrected duty cycle values ($TV_{LK}$, $TV_{HK}$) as an integer multiple of the PWM period ($T_{PWM}$),

the correction being made such that the arithmetic time average ($TV_M$) of the duty cycle signal (TV) is not changed substantially.

**2.** A method according to claim 1, **characterized in that** the basic portion ($S_G$) is determined by obtaining a measured value (M) of the electric current (I) flowing in the coil (3) and comparing it with a predefinable nominal value ($I_S$) as part of a control process.

**3.** A method according to claim 2, **characterized in that** the measured value (M) is subjected to low-pass filtering.

**4.** A method according to claim 1, **characterized in that** the duty cycle duration is set to the highest possible integer multiple of the PWM period ($T_{PWM}$).

**5.** A method according to claim 1, **characterized in that** the corrected low and high duty cycle values ($TV_{LK}$, $TV_{HK}$) are adjusted according to

$$TV_{LK} = TV_M \cdot \left[ 1 - \left( 1 - \frac{TV_M}{2 \cdot TV_0} \right) \cdot \frac{T_0}{T_0 - T_{PWM} \cdot n} \right]$$

or

$$TV_{HK} = TV_M \cdot \left[ 1 + \left( 1 - \frac{TV_M}{2 \cdot TV_0} \right) \cdot \frac{T_0}{T_{PWM} \cdot n} \right]$$

if the check shows that the fictitious low duty cycle value is smaller than zero, wherein $TV_M$ represents the basic portion, $TV_{\ddot{U}}$ represents the amplitude of the originally planned superimposed portion, $T_{\ddot{U}}$ represents the superposition period, $T_{PWM}$ represents the PWM period, and n represents a natural number.

6. A method according to claim 5, **characterized in that** the natural number n is set to the highest value which fulfils the conditions

$$n \leq \frac{TV_M}{2 \cdot TV_0} \cdot \frac{T_0}{T_{PWM}} \quad \text{and} \quad n \in \{0,1,2,3,\ldots\}.$$

7. A device for electrically triggering a valve (2) having a mechanical closure element (4), comprising

a) a PWM generator (7) for generating a pulse width modulated PWM signal ($S_P$) which has a predefined PWM period ($T_{PWM}$) and a duty cycle and on the basis of which an electric current (I) is fed into a coil (3) which interacts with the closure element (4), and
b) provision means (5, 6, 11) which are connected to the PWM generator (7) on the input side thereof and serve to provide a duty cycle signal (TV) which determines the duty cycle, wherein

b1) the provision means (5, 6, 11) contain an adder (6) in order to generate the duty cycle signal (TV) from a basic portion ($S_G$) and a superimposed portion ($S_{\ddot{U}}$) having a superposition period ($T_{\ddot{U}}$) during which the duty cycle signal (TV) changes between a high and a low duty cycle value ($TV_H$, $TV_L$, $TV_{HK}$, $TV_{LK}$), b2) the provision means (5, 6, 11) contain correction means (11) which are designed

b21) to check whether the addition of the basic portion ($S_G$) and the originally planned superimposed portion ($S_{\ddot{U}}$) yields a fictitious low duty cycle value ($TV_L$) smaller than zero or a fictitious high duty cycle value ($TV_H$) higher than one,
b22) to adapt these values by raising the low duty cycle value ($TV_L$) at least to zero and the high duty cycle value ($TV_H$) to a corrected high duty cycle value ($TV_{HK}$) or to adapt these values by lowering the high duty cycle value ($TV_H$) at the most to one and the low duty cycle value ($TV_L$) to a corrected low duty cycle value ($TV_{LK}$), and
b23) to set a duty cycle duration from the beginning of the superposition period ($T_{\ddot{U}}$) until switching between the two corrected duty cycle values ($TV_{LK}$, $TV_{HK}$) as an integer multiple of the PWM period ($T_{PWM}$),

the value adaptation of the duty cycle values ($TV_{LK}$, $TV_{HK}$) and the setting of the duty cycle duration not changing substantially the arithmetic time average ($TV_M$) of the duty cycle signal (TV).

8. A device according to claim 7, **characterized in that** the provision means (5, 6, 11) contain a control unit (5) for comparing a measured value (M) of the electric current (I) flowing in the coil (3) with a predefinable nominal value (Is).

9. A device according to claim 8, **characterized in that** a low pass filter (10) for filtering the measured value (M) is provided.

**10.** A device according to claim 7, **characterized in that** the correction means (11) are designed to set the duty cycle duration to the highest possible integer multiple of the PWM period ($T_{PWM}$).

**11.** A device according to claim 7, **characterized in that** the correction means (11) are designed to adjust the corrected low and high duty cycle values ($TV_{LK}$, $TV_{HK}$) according to

$$TV_{LK} = TV_M \cdot \left[ 1 - \left( 1 - \frac{TV_M}{2 \cdot TV_{\ddot{U}}} \right) \cdot \frac{T_{\ddot{U}}}{T_{\ddot{U}} - T_{PWM} \cdot n} \right]$$

or

$$TV_{HK} = TV_M \cdot \left[ 1 + \left( 1 - \frac{TV_M}{2 \cdot TV_{\ddot{U}}} \right) \cdot \frac{T_{\ddot{U}}}{T_{PWM} \cdot n} \right]$$

if the check shows that the fictitious low duty cycle value is smaller than zero, wherein $TV_M$ represents the basic portion, $TV_{\ddot{U}}$ represents the amplitude of the originally planned superimposed portion, $T_{\ddot{U}}$ represents the superposition period, $T_{PWM}$ represents the PWM period, and n represents a natural number.

**12.** A device according to claim 11, **characterized in that** the correction means (11) are designed to set the natural number n to the highest value which fulfils the conditions

$$n \leq \frac{TV_M}{2 \cdot TV_{\ddot{U}}} \cdot \frac{T_{\ddot{U}}}{T_{PWM}} \quad \text{and} \quad n \in \{0,1,2,3,...\}.$$

**Revendications**

**1.** Procédé de pilotage électrique d'une soupape (2) avec un élément de fermeture (4) mécanique, dans lequel

a) l'élément de fermeture (4) est déplacé au moyen d'un courant électrique (I) s'écoulant dans une bobine (3),
b) le courant électrique (I) est produit au moyen d'un signal PWM à modulation de largeur d'impulsions ($S_p$) qui présente une durée de période PWM ($T_{PWM}$) paramétrée et un taux d'impulsions,
c) le taux d'impulsions est réglé au moyen d'un signal de taux d'impulsions (TV) qui se compose de façon additive d'une fraction de base ($S_G$) et d'une fraction de superposition ($S_{\ddot{U}}$) avec une durée de période de superposition ($T_{\ddot{U}}$) à l'intérieur de laquelle le signal de taux d'impulsions (TV) est commuté entre une valeur de taux d'impulsions élevée et une valeur de taux d'impulsions faible ($TV_H$, $TV_L$; $TV_{HK}$, $TV_{LK}$),
d) il est vérifié si l'addition de la fraction de base ($S_G$) et de la fraction de superposition ($S_{\ddot{U}}$) prévue initialement fournit une valeur de taux d'impulsions ($TV_L$) faible fictive inférieure à zéro ou une valeur de taux d'impulsions ($TV_H$) élevée fictive supérieure à un et, dans l'affirmative, une correction est effectuée, par le fait que

d1) la valeur de taux d'impulsions ($TV_L$) faible est augmentée à au moins zéro, et la valeur de taux d'impulsions ($TV_H$) élevée est augmentée à une valeur de taux d'impulsions ($TV_{HK}$) élevée corrigée, ou la valeur de taux d'impulsions ($TV_H$) élevée est abaissée à un au maximum et la valeur de taux d'impulsions ($TV_L$) faible est abaissée à une valeur de taux d'impulsions ($TV_{HK}$) faible corrigée, et
d2) une durée de taux d'impulsions depuis le début de la durée de période de superposition ($T_{\ddot{U}}$) jusqu'à la commutation entre les deux valeurs de taux d'impulsions corrigées ($TV_{LK}$, $TV_{HK}$) est réglée en tant que multiple entier de la durée de période PWM ($T_{PWM}$),

la correction étant effectuée de sorte que la valeur moyenne temporelle arithmétique ($TV_M$) du signal de taux d'impulsions (TV) n'est pas modifiée de façon importante.

2. Procédé selon la revendication 1, **caractérisé en ce que** la fraction de base ($S_G$) est déterminée par le fait qu'une valeur de mesure (M) du courant électrique (I) s'écoulant dans la bobine (3) est définie et est comparée, dans le cadre d'une régulation, avec une valeur de consigne ($I_S$) paramétrable.

3. Procédé selon la revendication 2, **caractérisé en ce que** la valeur de mesure (M) est soumise à un filtrage passe-bas.

4. Procédé selon la revendication 1, **caractérisé en ce que** la durée de taux d'impulsions est réglée sur le multiple entier le plus grand possible de la durée de période PWM ($T_{PWM}$).

5. Procédé selon la revendication 1, **caractérisé en ce que** les valeurs de taux d'impulsions faible et élevée corrigées ($TV_{LK}$, $TV_{HK}$) sont réglées selon

$$TV_{LK} = TV_M \cdot \left[1 - \left(1 - \frac{TV_M}{2.TV_{\ddot{U}}}\right) \cdot \frac{T_{\ddot{U}}}{T_{\ddot{U}} - T_{PWM}.n}\right]$$

ou

$$TV_{HK} = TV_M \cdot \left[1 + \left(1 - \frac{TV_M}{2.TV_{\ddot{U}}}\right) \cdot \frac{T_{\ddot{U}}}{T_{PWM}.n}\right]$$

si la vérification montre que la valeur de taux d'impulsions faible fictive est inférieure à zéro, $TV_M$ désignant la fraction de base, $TV_{\ddot{U}}$ l'amplitude de la fraction de superposition prévue initialement, $T_{\ddot{U}}$ la durée de période de superposition, $T_{PWM}$ la durée de période PWM et n un nombre naturel.

6. Procédé selon la revendication 5, **caractérisé en ce que** le nombre naturel n est réglé sur la plus grande valeur qui respecte les conditions

$$n \leq \frac{TV_M}{2.TV_{\ddot{U}}} \cdot \frac{T_{\ddot{U}}}{T_{PWM}} \quad \text{et } n \in \{0,1,2,3, ...\}$$

7. Equipement de pilotage électrique d'une soupape (2) avec un élément de fermeture mécanique (4), comprenant

a) un générateur PWM (7) pour la production d'un signal PWM à modulation de largeur d'impulsions ($S_p$) qui présente une durée de période PWM ($T_{PWM}$) paramétrée et un taux d'impulsions, et sur la base duquel il se produit une alimentation d'un courant électrique (I) dans une bobine (3) coopérant avec l'élément de fermeture (4) et,
b) sur le côté entrée, des moyens de fourniture (5, 6, 11), raccordés au générateur PWM (7), pour la fourniture d'un signal de taux d'impulsions (TV) définissant le taux d'impulsions,

b1) les moyens de fourniture (5, 6, 11) comprenant un circuit d'addition (6) pour produire le signal de taux d'impulsions (TV) à partir d'une fraction de base ($S_G$) et d'une fraction de superposition ($S_{\ddot{U}}$) avec une durée de période de superposition ($T_{\ddot{U}}$) à l'intérieur de laquelle le signal de taux d'impulsions (TV) varie entre une valeur de taux d'impulsions élevée et une valeur de taux d'impulsions faible ($TV_H$, $TV_L$ ; $TV_{HK}$, $TV_{LK}$),

**12**

b2) les moyens de fourniture (5, 6, 11) contenant des moyens de correction (11) qui sont calculés

b21) pour vérifier si l'addition de la fraction de base ($S_G$) et de la fraction de superposition ($S_Ü$) prévue initialement fournit une valeur de taux d'impulsions ($TV_L$) faible fictive inférieure à zéro ou une valeur de taux d'impulsions ($TV_H$) élevée fictive supérieure à un,

b22) pour adapter les valeurs au moyen du relèvement de la valeur de taux d'impulsions ($TV_L$) faible à au moins zéro et de la valeur de taux d'impulsions ($TV_H$) élevée à une valeur de taux d'impulsions ($TV_{HK}$) élevée corrigée, ou pour adapter les valeurs au moyen de l'abaissement de la valeur de taux d'impulsions ($TV_H$) élevée à un au maximum et de la valeur de taux d'impulsions ($TV_L$) faible à une valeur de taux d'impulsions ($TV_{LK}$) faible corrigée, et

b23) pour régler une durée de taux d'impulsions depuis le début de la durée de période de superposition ($T_Ü$) jusqu'à la commutation entre les deux valeurs de taux d'impulsions ($TV_{LK}$, $TV_{HK}$) corrigées en tant que multiple entier de la durée de période PWM ($T_{PWM)}$,

l'adaptation de valeurs des valeurs de taux d'impulsions ($TV_{LK}$, $TV_{HK}$) et le réglage de la durée de taux d'impulsions ne modifiant pas de façon importante la valeur moyenne ($TV_M$) temporelle arithmétique du signal de taux d'impulsions ($TV$).

8. Equipement selon la revendication 7, **caractérisé en ce que** les moyens de fourniture (5, 6, 11) contiennent une régulateur (5) pour la comparaison d'une valeur de mesure (M) du courant électrique (I) s'écoulant dans la bobine (3) avec une valeur de consigne ($I_S$) paramétrable.

9. Equipement selon la revendication 8, **caractérisé en ce qu'**il est prévu un filtre passe-bas (10) pour le filtrage de la valeur de mesure (M).

10. Equipement selon la revendication 7, **caractérisé en ce que** les moyens de correction (11) sont calculés pour le réglage de la durée de taux d'impulsions sur le multiple entier le plus grand possible de la durée de période PWM ($T_{PWM}$).

11. Equipement selon la revendication 7, **caractérisé en ce que** les moyens de correction (11) sont calculés pour le réglage des valeurs de taux d'impulsions ($TV_{LK}$, $TV_{HK}$) faible et élevée corrigées selon

$$TV_{LK} = TV_M \cdot \left[ 1 - \left( 1 - \frac{TV_M}{2.TV_Ü} \right) . \frac{T_Ü}{T_Ü - T_{PWM}.n} \right]$$

ou

$$TV_{HK} = TV_M \cdot \left[ 1 + \left( 1 - \frac{TV_M}{2.TV_Ü} \right) . \frac{T_Ü}{T_{PWM}.n} \right]$$

dans le cas où la vérification indique que la valeur de taux d'impulsions faible fictive est inférieure à zéro, $TV_M$ désignant la fraction de base, $TV_Ü$ l'amplitude de la fraction de superposition prévue initialement, $T_Ü$ la durée de période de superposition, $T_{PWM}$ la durée de période PWM et n un nombre naturel.

12. Equipement selon la revendication 11, **caractérisé en ce que** les moyens de correction (11) sont calculés pour le réglage du nombre naturel n à la plus grande valeur qui respecte les conditions

$$n \leq \frac{TV_M}{2.TV_{\ddot{U}}} \cdot \frac{T_{\ddot{U}}}{T_{PWM}} \quad \text{et } n \in \{0,1,2,3, ...\}$$

EP 1 880 096 B1

Fig. 1

$$T_{\ddot{U}}$$

$$\alpha \cdot T_{\ddot{U}} = 0,5 \cdot T_{\ddot{U}} \qquad (1 - \alpha) \cdot T_{\ddot{U}} = 0,5 \cdot T_{\ddot{U}}$$

TV

TV$_H$

TV$_{\ddot{U}}$

TV$_M$

TV$_{\ddot{U}}$

TV$_L$

t

T$_{PWM}$

S$_P$

TV ·
T$_{PWM}$
T$_{PWM}$

T$_{PWM}$

t

Fig. 2

Fig. 3

Fig. 4

EP 1 880 096 B1